# EUROPÄISCHE PATENTSCHRIFT

(11) **EP 2 963 147 B1**
(45) Veröffentlichungstag und Bekanntmachung des Hinweises auf die Patenterteilung: **02.08.2017**
(21) Anmeldenummer: 15173776.4
(22) Anmeldetag: 25.06.2015
(51) Int. Cl.: C23C 14/12, C23C 14/24, C23C 14/26, C23C 16/448, C23C 16/455

(54) **VORRICHTUNG ZUM ERZEUGEN EINES DAMPFES AUS EINEM FESTEN ODER FLÜSSIGEN AUSGANGSSTOFF FÜR EINE CVD- ODER PVD-EINRICHTUNG**
DEVICE FOR GENERATING A VAPOUR FROM A SOLID OR LIQUID STARTING MATERIAL FOR A CVD OR PVD DEVICE
DISPOSITIF DE GENERATION D'UNE VAPEUR A PARTIR D'UNE MATIERE DE DEPART LIQUIDE OU SOLIDE POUR UN DISPOSITIF EN CVD OU PVD

(30) Priorität: 01.07.2014 DE 102014109196
(43) Veröffentlichungstag der Anmeldung: 06.01.2016
(73) Patentinhaber: Aixtron SE, 52134 Herzogenrath (DE)
(72) Erfinder: LONG, Michael, 52134 Herzogenrath (DE); POQUÉ, Andreas, 52074 Aachen (DE); CREMER, Claudia, 52428 Jülich (DE); BECCARD, Birgit Irmgard, 52066 Aachen (DE); TRIMBORN, Karl-Heinz, 41844 Wegberg (DE)
(74) Vertreter: Grundmann, Dirk

(56) Entgegenhaltungen:
- WO-A1-2007/141235
- DE-A1-102011 051 260
- US-A1- 2004 194 702
- US-A1- 2007 098 891

## Beschreibung

Die Erfindung betrifft eine Vorrichtung zum Erzeugen eines Dampfes für eine CVD- oder PVD-Einrichtung nach Anspruch 1 mit mindestens zwei in Strömungsrichtung eines Trägergases hintereinander angeordneten, Wärmeübertragungsflächen aufweisende Wärmeübertragungskörper, die jeweils auf eine Wärmeübertragungstemperatur aufheizbar sind, mit einem Zuleitungsrohr zur Zuleitung eines Aerosols zu einem der Wärmeübertragungskörper zur Verdampfung des Aerosols durch In-Kontakt-Bringen der Aerosol-Partikel mit den Wärmeübertragungsflächen.

Die DE 10 2011 051 260 A1 beschreibt eine Vorrichtung zum Erzeugen eines Dampfes. In einem Gehäuse sind mehrere, jeweils unterschiedliche Querschnitte aufweisende Wärmeübertragungskörper in Strömungsrichtung hintereinander angeordnet. Durch eine Gehäusestirnfläche ragt ein Zuleitungsrohr zum Einspeisen eines Aerosols durch einen stromaufwärtigen Wärmeübertragungskörper hindurch und mündet in eine zentrale Höhlung der Vorrichtung.
Bei einer in der WO 2012/175128 A1 beschriebenen Vorrichtung steckt in einem Gehäuse eine CVD- bzw. eine PVD-Einrichtung, eine Verdampfungsvorrichtung, die in Strömungsrichtung eines Aerosols zwei hintereinander angeordnete Wärmeübertragungskörper aufweist. Die beiden Wärmeübertragungskörper werden von elektrisch leitenden Festkörperschäumen gebildet, die durch Hindurchleiten eines elektrischen Stroms beheizt werden. Durch eine Zuleitung wird ein Aerosol in den Verdampfer eingebracht. Die Aerosolpartikel treten in Kontakt mit den Wärmeübertragungsflächen der Wärmeübertragungskörper, so dass die Partikel verdampft werden. Ähnliche Vorrichtungen werden in der WO 2012/175124 A1, WO 2010/175126 A1 sowie DE 10 2011051261 A1 beschrieben.

Aus der US 4,769,296 und US 4,885,211 ist die Fertigung von lichtemittierenden Dioden (OLED) aus organischen Ausgangsstoffen bekannt. Zur Fertigung dieser OLEDs müssen feste oder flüssige Ausgangsstoffe in eine Gasform gebracht werden. Dies erfolgt mit einem Verdampfer. Der vergaste Ausgangsstoff wird als Dampf in eine Prozesskammer eines CVD- bzw. PVD-Reaktors geleitet, wo der Dampf auf einem Substrat kondensiert.

Verfahren zum Abscheiden von Schichten im Niedrigdruckbereich beschreiben auch die US 2,447,789 und EP 0 982 411.

US 2004/0194702 beschreibt ein Beschichtungssystem bestehend aus einer Trägergaszuführung einem Verdampfer, einer Zuleitung zur Vakuumkammer, einer Vakuumkammer, einem Substrathalter und einem Gaseinlasselement. Die Trägergaszuführung und die Zuleitung zur Vakuumkammer werden durch eine Heizvorrichtung beheizt. Weiterhin beheizt wird auch der Verdampfer, in der die Trägergaszuführung mündet.

US 2007/0098891 zeigt ebenfalls ein Beschichtungssystem mit einem Verdampfer und einer Trägergaszuführung. Die Trägergaszuführung mündet in dem Verdampfer, wobei sich der Verdampfer innerhalb der Vakuumkammer befindet.

Ein gattungsgemäßes Verfahren bzw. eine gattungsgemäße Vorrichtung ist aus der WO 2007/141235 vorbekannt. Diese Schrift beschreibt eine Vakuumbeschichtungseinrichtung mit einer Trägergaszuführung, einem Vorratsbehälter für ein Pulvergemisch und einem Verdampfer, wobei der Trägergaszufluss das Pulvergemisch dem Verdampfer zuführt. Neben der Zuleitung des Pulvergemisches in den Verdampfer, ist eine weitere Trägergaszuleitung zum Verdampfer vorgesehen, wobei diese Trägergaszuleitung kein Pulvergemisch zuführt.

Die zum Abscheiden von OLEDs verwendeten Ausgangsstoffe dürfen nur einer maximalen Verdampfungstemperatur ausgesetzt werden, da sie bereits bei relativ geringen Temperaturen zerlegt werden. Diese chemische Zerlegungstemperatur sollte nicht oder darf nur für sehr kurze Zeit erreicht werden.

Der Erfindung liegt die Aufgabe zugrunde, einen gattungsgemäßen Verdampfer prozesstechnisch zu verbessern.

Gelöst wird die Aufgabe durch die in den Ansprüchen angegebene Erfindung.

Gemäß einem ersten Aspekt der Erfindung wird zunächst und im Wesentlichen vorgeschlagen, dass einer der Wärmeübertragungskörper eine Öffnung aufweist, in der ein Zuleitungsrohr steckt. Das Zuleitungsrohr besitzt eine Mündung, durch die ein Aerosol derart in das Gehäuse einspeisbar ist, dass die Aerosolpartikel durch in Kontaktbringen mit dem Wärmeübertragungsflächen verdampfen. Die Mündung des Zuleitungsrohres ist derart stromabwärts der Mündung der Trägergaszuleitung im Gehäuse angeordnet, dass das Trägergas zunächst in einem Vorheizkörper vorgeheizt wird, bevor es sich mit dem verdampften Aerosol mischt. Die Mündung der Zuleitung liegt deshalb stromabwärts eines stromaufwärtigen Bereichs des Vorheizkörpers, durch den das Trägergas strömt. Zufolge dieser Ausgestaltung ist es auch möglich, das Zuleitungsrohr entgegen der Strömungsrichtung des Trägergases in eine Öffnung des Wärmeübertragungskörpers hineinzustecken. Die Mündung der Zuleitung befindet sich dann im stromaufwärtigen Bereich des Wärmeübertragungskörpers oder in einem Zwischenraum zwischen dem die Öffnung aufweisenden Wärmeübertragungskörpers und einem gegenüber diesem Wärmeübertragungskörper stromaufwärts angeordneten Wärmeübertragungskörper. Erfindungsgemäß ist dabei bevorzugt vorgesehen, dass die Öffnung einem stromaufwärtigen Wärmeübertragungskörper zugeordnet ist und die Mündung das Zuleitungsrohr in Strömungsrichtung vor oder in einem stromabwärtigen Wärmeübertragungskörper angeordnet ist. Bevorzugt münden die ein oder mehreren Zuleitungsrohre aber in einen Abstandsraum zwischen zwei Wärmeübertragungskörpern, so dass das aus der Mündung des mindestens einen Zuleitungsrohres heraustretende Aerosol über eine möglichst große Fläche in den stromabwärtigen Wärmeübertragungskörper eintreten kann. Der in Strömungsrichtung erste und somit stromaufwärtige Wärmeübertragungskörper kann ein Vorheizkörper für ein Trägergas sein. Dieser erste Wärmeübertragungskörper kann die Öffnung aufweisen, durch die die Zuleitung zur Zuleitung eines Aerosols hindurch greift. Die Zuleitung mündet entweder in einem stromabwärtigen Wärmeübertragungskörper oder in einem Abstandsraum unmittelbar stromaufwärts des stromabwärtigen Wärmeübertragungskörpers. Zufolge dieser Ausgestaltung ist sichergestellt, dass durch den in Stromrichtung aufwärtigen Wärmeübertragungskörper nur das Trägergas hindurchströmt, welches vorgeheizt wird. In den stromabwärtigen Wärmeübertragungskörper wird hingegen zusätzlich zum Trägergas auch das Aerosol eingespeist, so dass die Aerosolpartikel in Kontakt zu den Wärmeübertragungsflächen des Wärmeübertragungskörpers treten können. Dort wird auf die Partikel die Verdampfungswärme übertragen, so dass die festen oder flüssigen Aerosolpartikel in die Gasform gebracht werden. Es ist insbesondere vorgesehen, dass kaskadenartig mehrere Wärmeübertragungskörper, die jeweils eine Verdampfungsfunktion ausüben, hintereinander angeordnet sind. Bei einer derartigen Anordnung ist es vorgesehen, dass auch ein stromabwärtiger Wärmeübertragungskörper, der die Funktion eines Verdampfungskörpers aufweist, eine oder mehrere Öffnungen aufweist, durch die eine Zuleitung hindurchgesteckt ist, welche in einen bezogen auf diesen Wärmeübertragungskörper stromabwärtigen Abstandsraum oder in einen stromabwärtigen Wärmeübertragungskörper münden. Zufolge dieser Ausgestaltung wird in einem stromaufwärtigen Verdampfungskörper ein erstes Aerosol verdampft und in einem stromabwärtigen Verdampfungskörper ein zweites Aerosol verdampft. Die beiden Aerosole können bei unterschiedlichen Verdampfungstemperaturen verdampft werden. Bevorzugt wird das eine niedrige Verdampfungstemperatur aufweisende Aerosol in einen stromaufwärtigen Verdampfungskörper eingespeist und das eine hohe Verdampfungstemperatur aufweisende Aerosol in einen stromabwärtigen Verdampfungskörper eingespeist. Der stromabwärtige Verdampfungskörper hat dann eine höhere Wärmeübertragungstemperatur als die Wärmeübertragungstemperatur des stromaufwärtigen Verdampfungskörpers. Es können somit drei oder mehr Wärmeübertragungskörper in Stromrichtung hintereinander angeordnet sein, wobei der in Strömungsrichtung erste Wärmeübertragungskörper lediglich zum Aufheizen eines Trägergases dient und die mehreren stromabwärtigen Wärmeübertragungskörper jeweils zum Aufheizen eines Aerosols und zum Verdampfen des Aerosols verwendet werden. Das in einem stromaufwärtigen Verdampfungskörper verdampfte Aerosol durchtritt als Dampf den stromabwärtigen Verdampfungskörper, in den durch eine Zuleitung ein anderes Aerosol eingespeist wird. Die Verdampfungskörper werden bevorzugt aus dem Material gefertigt, wie es in der WO 2012/175128 A1 beschrieben wird. Es handelt sich um einen offenzelligen Festkörperschaum mit einer Porösität von 400 bis 100 Poren pro Zoll. Der Verdampfungskörper ist elektrisch leitfähig, so dass er durch Hindurchleiten eines elektrischen Stromes auf seine Verdampfungstemperatur aufheizbar ist. Hierzu besitzt der bevorzugt einen rechteckigen Grundriss aufweisende Verdampfungskörper an zwei sich gegenüberliegenden Schmalseiten elektrische Kontakte, durch die der elektrische Strom in den Verdampfungskörper eingeleitet werden kann. Die Zuleitungsrohre können aus elektrisch isoliertem Material oder aus Metall bestehen. Sofern die Zuleitungsrohre aus Metall bestehen, sind sie in dem Bereich der Öffnungen von einer elektrisch isolierenden Hülse umgeben. Die Wärmeübertragungskörper, von denen zumindest einer einen Verdampfungskörper ausbildet, befinden sich in einem Gehäuse. Sie erstrecken sich über die gesamte Gehäusequerschnittsfläche, so dass das stromaufwärts in das Gehäuse eingespeiste Trägergas durch sämtliche hintereinander angeordnete Wärmeübertragungskörper strömen muss. Das Aerosol bzw. der aus dem Aerosol erzeugte Dampf durchströmt zumindest den in Strömungsrichtung letzten Wärmeübertragungskörper. Die Dampfaustrittsfläche des letzten Wärmeübertragungskörpers kann eine Gaseintrittsfläche sein, durch die das Trägergas und die vom Trägergas transportierten verdampften Aerosole in eine Prozesskammer eingeleitet werden. Die Prozesskammer des CVD- PVD-Reaktors befindet sich somit in Strömungsrichtung unmittelbar unterhalb des in Strömungsrichtung letzten Wärmeübertragungskörpers. Durch die Gasaustrittsfläche dieses Wärmeübertragungskörpers tritt ein im Wesentlichen homogener Gasstrom in die Prozesskammer ein. Auf dem Boden der Prozesskammer befindet sich ein Substrat, auf welchem der Dampf kondensieren soll. Der Suszeptor, der das Substrat trägt, wird bevorzugt von einer Kühleinrichtung gekühlt.

Ein zweiter Aspekt der Erfindung betrifft eine Rückstromsperre, die in Strömungsrichtung vor dem ersten Wärmeübertragungskörper angeordnet ist. Die Rückstromsperre befindet sich somit zwischen der Trägergaszuleitung und dem ersten Wärmeübertragungskörper. Die Rückstromsperre besteht bevorzugt aus zwei plattenförmigen Körpern, die sich über die gesamte Querschnittsfläche des Gehäuses des Verdampfers erstrecken. Die beiden Platten besitzen Öffnungen, durch die das Trägergas hindurchströmen kann. Die Öffnungen der beiden Platten liegen versetzt zueinander, so dass das Trägergas zunächst durch die Öffnungen der stromaufwärtigen Rückstromsperrplatte hindurchtreten muss, dann in einen Zwischenraum umgelenkt wird, um anschließend durch die Öffnungen der zweiten Rückstromsperrplatte hindurch zu strömen.

Die Erfindung betrifft darüber hinaus die Weiterbildung eines Zuleitungsrohres. Das erfindungsgemäße Zuleitungsrohr besitzt Mittel, mit denen der aus der Mündung des Zuleitungsrohres heraustretende Gasstrom aufgeweitet wird, so dass der Gasstrom über eine möglichst große Fläche in den Wärmeübertragungskörper eintreten kann. Ein erfindungsgemäß weitergebildetes Zuleitungsrohr mündet bevorzugt in einen Abstandszwischenraum zwischen zwei Wärmeübertragungskörpern. Es kann aber auch stromaufwärts eines Wärmeübertragungskörpers in einen Volumenabschnitt eines Gehäuses münden. Das Zuleitungsrohr besitzt bevorzugt zwei Strömungskanäle, wobei ein erster Strömungskanal zur Durchleitung des Aerosols und ein zweiter Strömungskanal zum Einspeisen eines Trägergases durch Durchtrittsöffnungen in den ersten Strömungskanal vorgesehen ist. Durch das durch die Durchtrittsöffnung in den ersten Strömungskanal mündende Trägergas wird die Strömung innerhalb des ersten Strömungskanals beeinflusst. Der erste Strömungskanal besitzt bevorzugt eine Querschnittsfläche, die größer ist als die Querschnittsfläche des zweiten Strömungskanals. Mit den Trägergasströmen, die durch die ein oder mehreren Gasdurchtrittsöffnungen hindurchtreten, kann innerhalb des ersten Strömungskanals eine turbulente Strömung erzeugt werden. Hierzu sind insbesondere erste Gasdurchtrittsöffnungen vorgesehen, die in einem spitzen Winkel zur Erstreckungsrichtung des ersten Strömungskanales bzw. zur Strömungsrichtung des Aerosols in den ersten Strömungskanal münden. Es können zweite Gasdurchtrittsöffnungen vorgesehen sein, die insbesondere in Strömungsrichtung den ersten Gasdurchtrittsöffnungen nachgeordnet und besonders bevorzugt im Bereich der Mündung des Zuleitungsrohres angeordnet sind. Mit diesen zweiten Gasdurchtrittsöffnungen soll ein Drall erzeugt werden. Die zweiten Gasdurchtrittsöffnungen münden nicht nur spitzwinklig zur Erstreckungsrichtung des ersten Strömungskanales, also zur Strömungsrichtung des Aerosols in den ersten Strömungskanal. Die zweiten Gasdurchtrittsöffnungen sind vielmehr auch schräg bezogen auf eine Querschnittsebene durch den Strömungskanal ausgerichtet, so dass sie ein im Uhrzeigersinn oder im Gegenuhrzeigersinn drehender Trägergasstrom in den ersten Strömungskanal eingespeist wird. Hierdurch wird ein Wirbel erzeugt. Die damit einhergehenden Fliehkräfte bewirken eine Aufweitung des aus der Mündung der Zuleitung austretenden Gasstroms. In einer Weiterbildung der Erfindung ist ferner vorgesehen, dass die beiden Strömungskanäle aus zwei ineinander geschachtelten Rohren ausgebildet sind, so dass die Strömungskanäle koaxial zueinander angeordnet sind, wobei durch den inneren Strömungskanal das Aerosol strömt. Das den ersten Strömungskanal ausbildende Rohr besitzt an seiner Mündung eine Aufweitung, so dass sich die Querschnittsfläche des ersten Strömungskanals mündungsseitig in Stromrichtung bis zum Ende des Zuleitungsrohres stetig vergrößert. Auch dies führt zu einer Aufweitung des aus der Mündung heraustretenden Gasstroms. Es sind in Strömungsrichtung mehrere erste und zweite Gasdurchtrittsöffnungen hintereinander liegend angeordnet. Das Zuleitungsrohr besitzt einen zentralen Strömungskanal, durch den das Aerosol hindurch strömt. Dieser Strömungskanal ist von einer Wandung umgeben. Diese Wandung ist bevorzugt gekühlt. Hierzu sind Mittel zur Kühlung der Wandung des Strömungskanales vorgesehen. Es kann sich dabei um einen Strömungskanal handeln, in den ein kaltes Kühlmittel eingespeist wird. Bei dem Kühlmittel kann es sich um ein Trägergas handeln, das durch die zuvor beschriebene Öffnung aus einem radial äußeren Strömungskanal in einen radial inneren Strömungskanal hineinströmt. Es ist aber auch möglich, die Wandung des von dem Aerosol durchströmten Strömungskanals mit einer Kühlmanschette zu umgeben, die bspw. flüssigkeitsgekühlt ist oder bei der anderen Maßnahmen vorgesehen sind, um Wärme abzutransportieren. Hierdurch wird zum einen verhindert, dass eine Verdampfung und eventuelle Rekondensation des Aerosols innerhalb der Zuleitung stattfindet. AlQ3 geht unter Vacuumbedingungen vom festen Zustand unmittelbar in den gasförmigen Zustand über. Andere organische Materialien, bspw. NPD schmelzen vor der Verdampfung. Es ist deshalb vorgesehen, dass zum anderen die Wandung des Strömungskanals auf einer Temperatur unterhalb des Schmelzpunktes des Aerosolpartikels gehalten wird. Hierdurch wird ein Aufschmelzen der Aerosolpartikel innerhalb der Zuleitung verhindert.

Ausführungsbeispiele der Erfindung werden nachfolgend anhand beigefügter Zeichnungen erläutert. Es zeigen:
- Fig. 1: in Form eines Längsschnittes ein erstes Ausführungsbeispiel der Erfindung, bei dem eine Verdampfungseinrichtung stromaufwärts eines CVD-Reaktors angeordnet ist;
- Fig. 2: ein zweites Ausführungsbeispiel der Erfindung, bei dem die Gasaustrittsfläche des in Strömungsrichtung letzten Wärmeübertragungskörpers 3 gleichzeitig eine Gaseintrittsfläche einer Prozesskammer 15 ist;

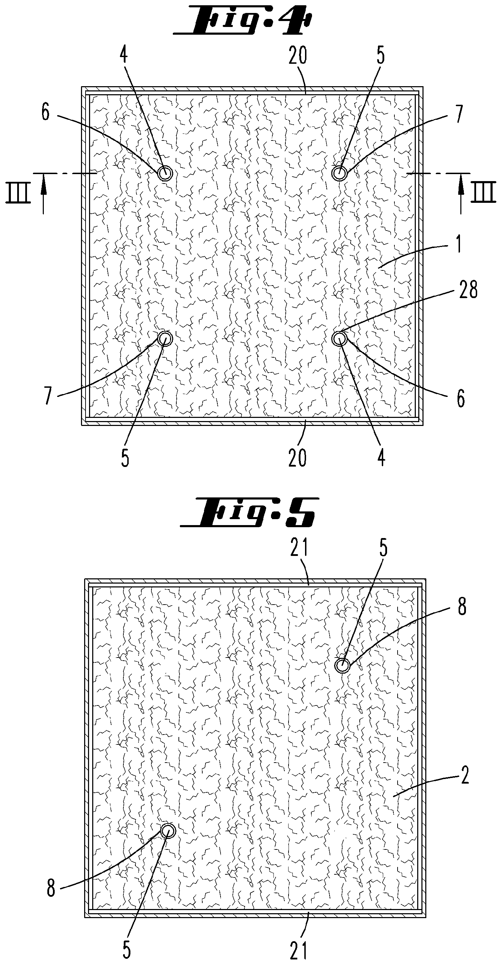

- Fig. 3: ein drittes Ausführungsbeispiel der Erfindung ebenfalls in einer Längsschnittdarstellung gemäß Linie III - III in Fig. 4;
- Fig. 4: den Schnitt gemäß der Linie IV - IV in Fig. 3;
- Fig. 5: den Schnitt gemäß der Linie V - V in Fig. 3;
- Fig. 6: ein viertes Ausführungsbeispiel der Erfindung;
- Fig. 7: ein fünftes Ausführungsbeispiel der Erfindung;
- Fig. 8: ein sechstes Ausführungsbeispiel der Erfindung;
- Fig. 9: in perspektivischer Darstellung ein erfindungsgemäßes Zuleitungsrohr;
- Fig. 10: den Längsschnitt durch das in Fig. 9 dargestellte Zuleitungsrohr;
- Fig. 11: den Schnitt gemäß der Linie XI - XI in Fig. 10 und
- Fig. 12: den Schnitt gemäß der Linie XII - XII in Fig. 10.

Die in den Zeichnungen lediglich schematisch dargestellten Vorrichtungen dienen zum Abscheiden von OLED-Schichten auf Substraten 14, die auf einem gekühlten Suszeptor 13 an einer Prozesskammer 15 liegen. In die Prozesskammer 15 wird ein aus verdampften Aerosolen erzeugtes Prozessgas eingespeist.

Dies erfolgt mit Hilfe eines Trägergases, welches durch eine Trägergaszuleitung 11 in das Gehäuse 12 eines Verdampfers eingespeist wird. In dem Verdampfer befinden sich mehrere Wärmeübertragungskörper 1, 2, 3. Die Wärmeübertragungskörper 1, 2, 3 erstrecken sich über die gesamte Querschnittsfläche des Verdampfergehäuses 12 und sind in Strömungsrichtung hintereinander angeordnet. Dies hat zur Folge, dass das durch die Trägergaseinspeiseöffnung 11 eingeleitete Trägergas, bei dem es sich um ein Inertgas, H₂, N₂ oder ein Edelgas handelt, sämtliche Wärmeübertragungskörper 1, 2, 3 in Strömungsrichtung durchströmt.

Ein in Strömungsrichtung zuoberst angeordneter Wärmeübertragungskörper 1 bildet in den Ausführungsbeispielen einen Vorheizkörper zum Vorheizen des Trägergases. Es ist aber auch vorgesehen, dass die Vorheizung des Trägergases außerhalb des Verdampfergehäuses 12 stattfindet, so dass der in Strömungsrichtung des Trägergases innerhalb des Verdampfergehäuses 12 zuerst angeordnete Wärmeübertragungskörper ein Verdampfungskörper für eines der Aerosole ist.

Es sind zwei in Strömungsrichtung hintereinander angeordnete Verdampfungskörper 2, 3 vorgesehen, die in sämtlichen Ausführungsbeispielen stromabwärts des Vorheizkörpers 1 liegen. Mittels Zuleitungen 4, 5 werden in die Verdampfungskörper 2, 3 voneinander verschiedene Aerosole eingespeist. Dies erfolgt derart, dass durch das Zuleitungsrohr 4 ein erstes Aerosol mit einer niedrigen Verdampfungstemperatur in einem stromaufwärtigen Verdampfungskörper 2 verdampft wird und ein zweites Aerosol, welches eine höhere Verdampfungstemperatur aufweist, in einen zweiten Verdampfungskörper 3, der stromabwärts des ersten Verdampfungskörpers 3 angeordnet ist, eingespeist wird.

Der Vorheizkörper 1 und die beiden diesem gegenüber stromabwärts angeordneten Verdampfungskörper 2, 3 werden jeweils von einem Wärmeübertragungskörper ausgebildet. Die Wärmeübertragungskörper 1, 2, 3 bestehen aus einem Festkörperschaum. Der Festkörperschaum hat offene Zellen und eine Porösität im Bereich zwischen 400 und 100 Poren pro Zoll.

Die Einspeisung der Aerosole erfolgt erfindungsgemäße durch rohrförmige Zuleitungen 4, 5, die Öffnungen 6, 7, 8 von Wärmeübertragungskörpern 1, 2, 3 durchragen oder in Öffnungen 6, 8 der Wärmeübertragungskörper 2, 3 hineingesteckt sind. Die Öffnungen erstrecken sich bevorzugt in Strömungsrichtung des Trägergases, wobei die Zuleitungsrohre dann entweder in Strömungsrichtung oder entgegen der Strömungsrichtung in die Öffnung 6, 7, 8 eingesteckt sind.

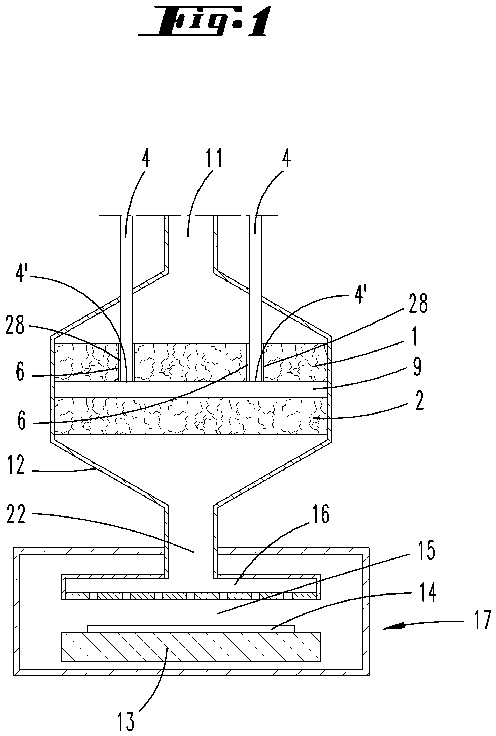

Bei dem in der Figur 1 dargestellten Ausführungsbeispiel ist lediglich ein Verdampfungskörper 2 vorgesehen. Dieser befindet sich zusammen mit einem Vorheizkörper 1 für das Trägergas in dem Gehäuse 12 der Verdampfungseinrichtung. Der Vorheizkörper 1, also der stromaufwärtige Wärmeübertragungskörper 1, ist vom stromabwärtigen Wärmeübertragungskörper 2, also einem Verdampfungskörper in Strömungsrichtung beabstandet. Es bildet sich somit ein Abstandsraum 9 zwischen den beiden Wärmeübertragungskörpern 1, 2, aus. In diesen Abstandsraum 9 münden die Mündungen 4' von Zuleitungsrohren 4, die sich in Strömungsrichtung des Trägergases 11 erstreckende Öffnungen 6 des Wärmeübertragungskörpers 1 durchgreifen. Der Innendurchmesser der Öffnungen 6 entspricht dem Außendurchmesser der Zuleitungsrohre 4, so dass die Zuleitungsrohre 4 berührend an der Innenwandung der Öffnung 6 anliegen. Durch die Zuleitungen 4 wird ein Aerosol in den Abstandsraum 9 eingespeist. Das Aerosol wird zusammen mit dem durch das Hindurchtreten durch den Vorheizkörper 1 vorgeheizte Trägergas in den zweiten Wärmeübertragungskörper 2 transportiert. Dort treten die Partikel des Aerosols in berührenden Kontakt zu den Wärmeübertragungsflächen des Wärmeübertragungskörpers 2. Den Partikeln des Aerosols wird Verdampfungswärme zugeführt, so dass aus der Gasaustrittsfläche des Wärmeübertragungskörpers 2 ein verdampftes Aerosol zusammen mit dem Trägergas austritt. Die Wärmezufuhr erfolgt durch elektrischen Strom. Durch eine Gasaustrittsöffnung 22 gelangen der Dampf und das Trägergas aus dem Verdampfer 12 heraus und in ein Gaseinlassorgan 16 eines CVD-Reaktors 17. Durch Gasaustrittsöffnungen des Gaseinlassorganes 16 treten das Trägergas und das verdampfte Aerosol in die Prozesskammer 15 ein. die Zuleitungsrohre 4 bestehen aus Metall und sind mittels Isolationshülsen 28 gegenüber dem Wärmeübertragungskörper 1 isoliert.

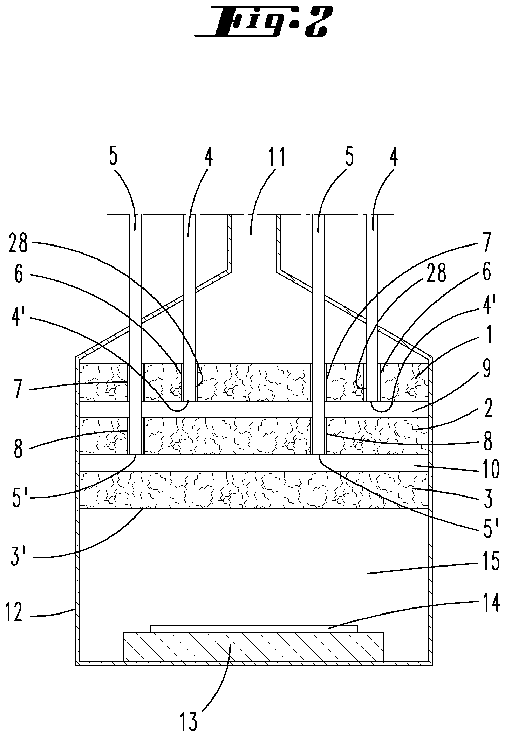

Bei dem in der Figur 2 dargestellten zweiten Ausführungsbeispiel ist unterhalb des Wärmeübertragungskörpers 2 ein weiterer Wärmeübertragungskörper 3 angeordnet. Zwischen dem Wärmeübertragungskörper 2 und dem Wärmeübertragungskörper 3 bildet sich ein zweiter Abstandsraum 10 aus. In den Abstandsraum 10 münden Zuleitungsrohre 5 zum Einspeisen eines zweiten Aerosols in den Abstandsraum 10. Die Zuleitungsrohre 5 stecken in Öffnungen 7 des Wärmeübertragungskörpers 1 und Öffnungen 8 des Wärmeübertragungskörpers 2. Das zweite Aerosol wird somit durch das Zuleitungsrohr 5 durch beide Wärmeübertragungskörper 1 und 2 geleitet.

Die Wärmeübertragungskörper 2, 3 können auch mit derselben Wärmeübertragungstemperatur betrieben werden. Bevorzugt besitzt der stromabwärtige Wärmeübertragungskörper 3 aber eine höhere Wärmeübertragungstemperatur als der stromaufwärtige Wärmeübertragungskörper 2 bzw. der Vorheizkörper 1. Hierdurch ist es möglich, in dem Wärmeübertragungskörper 3 ein zweites Aerosol zu verdampfen, welches eine höhere Verdampfungstemperatur aufweist als das erste Aerosol, welches durch Zuleitungen 4 in den Zwischenraum 9 und in den Wärmeübertragungskörper 2 eingespeist wird.

Im Unterschied zum ersten Ausführungsbeispiel bildet hier die Gasaustrittsfläche 3' des in Strömungsrichtung letzten Wärmeübertragungskörpers 3 eine Einspeisefläche aus, durch die das verdampfte Aerosol zusammen mit dem Trägergas in die Prozesskammer 15 eintritt.

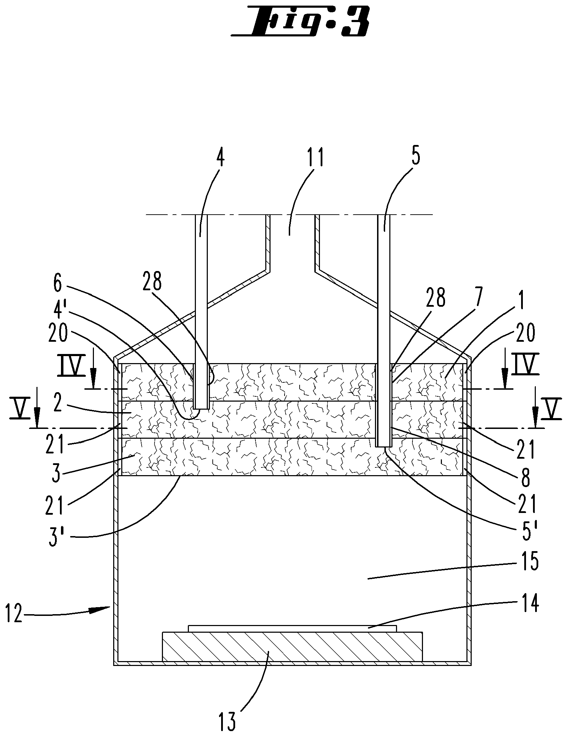

Bei dem in der Figur 3 dargestellten Ausführungsbeispiel liegen die drei in Strömungsrichtung hintereinander angeordneten Wärmeübertragungskörper 1, 2, 3 in berührender Anlage aneinander, so dass es keine Abstandsräume zwischen den in Strömungsrichtung aufeinander folgenden Wärmeübertragungskörpern 1, 2, 3 gibt. Bei diesem Ausführungsbeispiel befindet sich die Mündung 4' des Zuleitungsrohres 4 in einem stromaufwärtigen Abschnitt des ersten Verdampfungskörpers 2. Das zweite Zuleitungsrohr 5 durchdringt ebenso wie das erste Zuleitungsrohr 4 eine Öffnung des in Strömungsrichtung ersten Wärmeübertragungskörpers 1 und zusätzlich eine Öffnung 8 des in Strömungsrichtung zweiten Wärmeübertragungskörpers 2, so dass die Mündung 5' des Zuleitungsrohres 5 in einen stromaufwärtigen Abschnitt des dritten Wärmeübertragungskörpers 3 mündet. Auch hier werden bei voneinander verschiedenen Temperaturen in voneinander verschiedenen Wärmeübertragungskörpern 2, 3 zwei voneinander verschiedene Aerosole verdampft.

Die Zuführung der Verdampfungsenergie erfolgt durch Zuleitung von elektrischem Strom. Hierzu weisen die Wärmeübertragungskörper 1, 2, 3 elektrische Kontaktflächen 20, 21 auf. Im Ausführungsbeispiel besitzen die Wärmeübertragungskörper einen rechteckigen Grundriss, so dass die elektrischen Kontaktflächen 20, 21 einander gegenüberliegenden Schmalseitenwänden des Wärmeübertragungskörpers 1, 2, 3 zugeordnet sind.

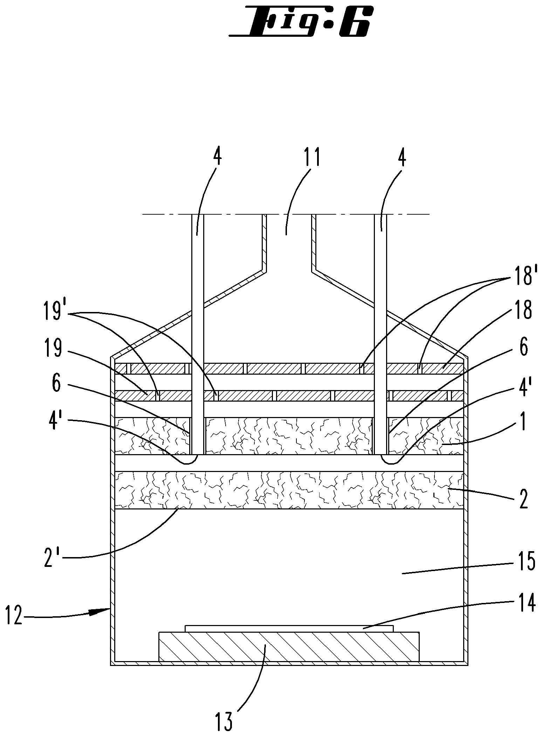

Das in der Figur 6 dargestellte vierte Ausführungsbeispiel zeigt zusätzlich eine Rückstromsperre, die von zwei plattenförmigen Rückstromsperrplatten 18,19 ausgebildet sind. Die beiden Rückstromsperrplatten 18,19 befinden sich in Strömungsrichtung zwischen der Einspeiseöffnung 11 zum Einspeisen des Trägergases und dem in Strömungsrichtung ersten Wärmeübertragungskörper 1. Die Rückstromsperrplatten 18,19 werden von den Zuleitungsrohren 4, 5 durchdrungen. Sie besitzen hierzu entsprechende Öffnungen. Wesentlich an den Rückstromsperrplatten 18,19 sind Öffnungen 18' der Rückstromsperrplatte 18 und Öffnungen 19' der Rückstromsperrplatte 19. Die Öffnungen 18' bzw. 19' liegen in Strömungsrichtung versetzt zueinander, so dass ein aus der Trägergaszuleitung 11 in das Gehäuse 12 eintretende Trägergas zunächst durch die Öffnungen 18' der stromaufwärtigen Rückstromsperrplatte 18 hindurchtreten müssen, dann in einen Abstandsraum zwischen den beiden Rückstromsperrplatten 18,19 umgelenkt werden, um anschließend durch die Öffnungen 19' der stromabwärtigen Rückstromsperrplatte 19 auszutreten. Die Rückstromsperrplattenanordnung soll verhindern, dass aus der stromaufwärtigen Oberfläche der Wärmeübertragungskörper ausgetretener Dampf eines erzeugten Aerosols in den oberen Bereich des Verdampfungsgehäuses 12 eintreten kann.

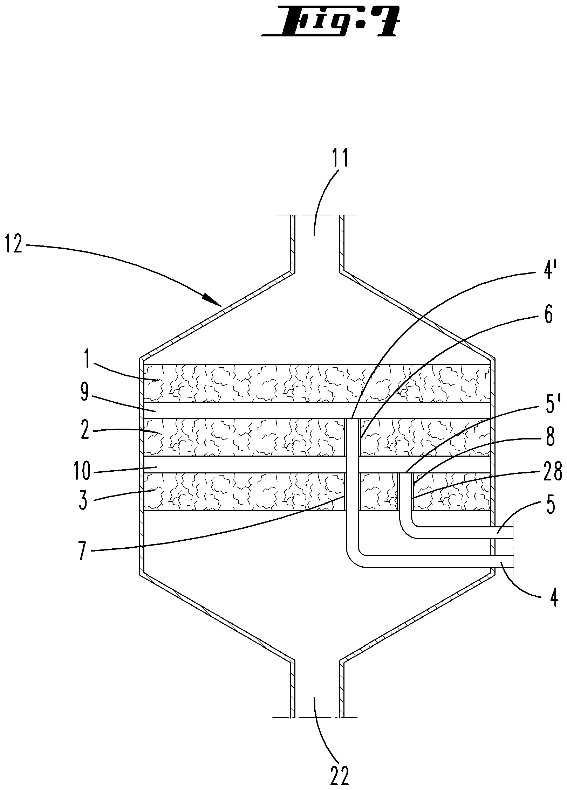

Bei dem in der Figur 7 dargestellten fünften Ausführungsbeispiel erfolgt die Zuleitung der Aerosole nicht durch in Strömungsrichtung des Trägergases in die Wärmeübertragungskörper 1, 2 hineingesteckte Zuleitungsrohre 4, 5, sondern durch Zuleitungsrohre 4, 5, die entgegen der Strömungsrichtung des Trägergases in Öffnungen 6, 7, 8 der Wärmeübertragungskörper 2, 3 eingesteckt sind. Die Zuführung der Zuleitungsrohre 4, 5 erfolgt hier gewissermaßen von unten. Das Zuleitungsrohr 4, durch welches das erste Aerosol in den Zwischenraum 9 zwischen dem Vorheizkörper 1 und dem ersten Verdampfungskörper 2 mündet, durchdringt somit Öffnungen 7, 6 beider Verdampfungskörper 2, 3. Auch hier und wie in allen Ausführungsbeispielen liegen die Außenwandungen der Zuleitungsrohre 4, 5 bzw. die Außenwandungen der die Zuleitungsrohre 4, 5 umgebenden Isolierhülse 28 in berührender Anlage an der Innenwandung der jeweiligen Öffnung 6, 7, 8 des jeweiligen Wärmeübertragungskörpers 1, 2, 3 an.

Das Zuleitungsrohr 5, dessen Mündung 5' im zweiten Zwischenraum 10 zwischen dem Verdampfungskörper 2 und dem Verdampfungskörper 3 angeordnet ist, durchdringt lediglich eine Öffnung 8 des in Strömungsrichtung stromabwärtigen Verdampfungskörpers 3.

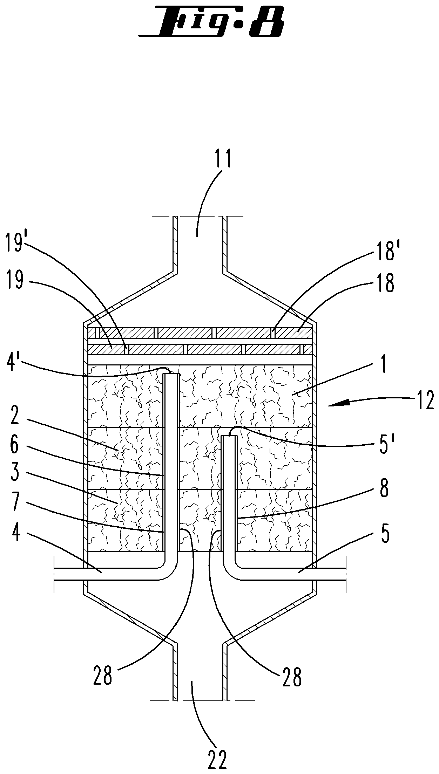

Das in der Figur 8 dargestellte sechste Ausführungsbeispiel zeigt eine Verdampfungseinrichtung 12, bei der drei Wärmeübertragungskörper 1, 2, 3 ähnlich dem in der Figur 3 dargestellten dritten Ausführungsbeispiel in Strömungsrichtung des Trägergases unmittelbar hintereinander angeordnet sind. Zusätzlich besitzt dieses Ausführungsbeispiel die oben beschriebene Rückstromsperrplattenanordnung 18,19.

Die Mündung 4' des Zuleitungsrohres 4 mündet hier in den unterhalb des Vorheizkörpers 1 angeordneten ersten Verdampfungskörper 2, und zwar unmittelbar unterhalb dessen oberer Randkante. Die Mündung 5' der Zuleitung 5 befindet sich unmittelbar unterhalb des oberen Randes des zweiten Verdampfungskörpers 3. Hier steckt das Zuleitungsrohr 5 in einer Öffnung 8 des Verdampfungskörpers 3. Das Zuleitungsrohr 4 steckt in einer Öffnung 6 des Verdampfungskörpers 2 und durchdringt eine Öffnung 7 des Verdampfungskörpers 3.

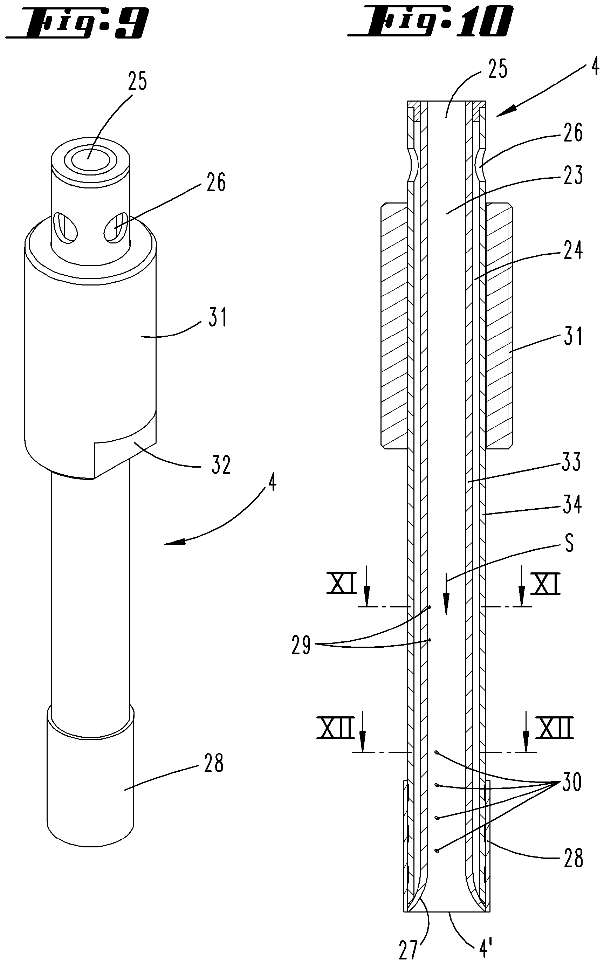

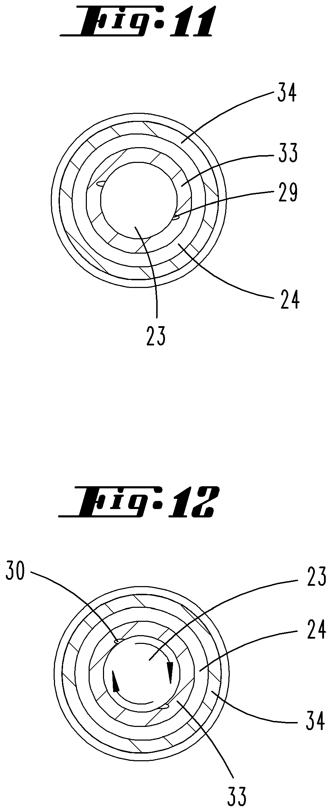

Die Figuren 9 bis 12 zeigen ein erfindungsgemäß ausgebildetes Zuleitungsrohr 4. Das Zuleitungsrohr 4 besteht aus zwei konzentrisch ineinander geschachtelten Rohren 33, 34, wobei der obere und untere Rand des Innenrohres 33 gasdicht mit dem oberen und unteren Rand des Außenrohres 34 verbunden ist. Die Rohröffnung des inneren Rohres 33 bildet einen ersten Strömungskanal 23 aus, durch den ein Aerosol hindurch geleitet werden kann, welches durch eine axiale Einspeiseöffnung 25 in den ersten Strömungskanal 23 eingespeist wird. Das Innenrohr 33 ist im Bereich der Mündung 4' des Zuleitungsrohres 4 radial nach außen aufgeweitet. Der mündungsseitige Endabschnitt des Außenrohres 34 ist von einer Manschette 28 aus isolierendem Werkstoff umgeben. Die Rohre 33, 34 selbst sind aus Metall, insbesondere Edelstahl gefertigt.

Das Außenrohr 34 besitzt insgesamt vier radiale Einspeiseöffnungen 26, durch die ein Trägergas in den Strömungskanal 24 eingespeist werden kann, der sich zwischen Innenrohr 33 und Außenrohr 34 befindet. Der Strömungskanal 24 ist über erste Durchtrittsöffnungen 29 und zweite Durchtrittsöffnungen 30 mit dem ersten, inneren Strömungskanal 23 verbunden. Die derart ausgebildeten Gasdurchtrittsöffnungen 29, 30 werden von durchmessergeringen Bohrungen ausgebildet, so dass dort Gasströme mit einer hohen Strömungsgeschwindigkeit hindurchtreten können. Die ersten Gasdurchtrittsöffnungen 29 besitzen eine Neigung, so dass die dort austretenden "Gasstrahlen" schräg zur Strömungsrichtung S in den Strömungskanal 23 eintreten. Die Gasdurchtrittsöffnungen 29 können nicht nur eine Neigung in Strömungsrichtung S, sondern auch eine Neigung in Tangentialrichtung besitzen, so dass die aus ihnen heraustretenden Gasströme auch einen Wirbel erzeugen können. Die ersten Gasdurchtrittsöffnungen 29 dienen zur Erzeugung einer Turbulenz innerhalb des ersten Strömungskanals 23. Die ersten Gasdurchtrittsöffnungen 29 sind stromaufwärts der zweiten Gasdurchtrittsöffnungen 30 angeordnet. Es sind mehrere erste Gasdurchtrittsöffnungen 29 in Umfangsrichtung und in Erstreckungsrichtung des Zuleitungsrohres 4 vorgesehen. Durch den Strömungskanal 24 kann ein die Wandung des Strömungskanals 23 kühlender Gasstrom hindurch strömen, um zu verhindern, dass die Temperatur innerhalb des Zuleitungsrohres eine Temperatur überschreitet, die zu einer Verdampfung des Aerosols oder zu einem Schmelzen fester Aerosolpartikel führt. Eine eventuell dann erfolgende Rekondensation oder ein Schmelzen könnte das Zuleitungsrohr ansonsten verstopfen.

Die zweiten Gasdurchtrittsöffnungen 30 befinden sich nahe der Mündung 4'. Auch hier sind mehrere zweite Gasdurchtrittsöffnungen 30 sowohl in Umfangsrichtung als auch in Erstreckungsrichtung des Zuleitungsrohres 4 angeordnet. Die die Gasdurchtrittsöffnungen 30 ausbildenden Bohrungen besitzen einen Tangentialwinkel zum Innenrohr 33, so dass die aus den zweiten Gasdurchtrittsöffnungen 30 heraustretenden "Gasstrahlen" dem in Strömungsrichtung S strömenden Aerosolstrom einen Wirbel aufzwingen. Dies hat in Kombination mit der Aufweitung 27 eine Aufweitung des aus der Mündung 4' austretenden Gasstroms zur Folge. Die die zweiten Gasdurchtrittsöffnungen 30 ausbildenden Bohrungen können darüber hinaus auch eine Neigung bezogen auf die Erstreckungsrichtung des Zuleitungsrohres 4 aufweisen.

Die Aufweitung 27 erstreckt sich bis zur unteren Randkante des äußeren Rohres 34 und bildet somit den mündungsseitigen Verschluss des Strömungskanals 24. Als Folge des im Mündungsbereich erzeugten Wirbels erhält der die Mündung verlassende Aerosolstrom eine quer zur Erstreckungsrichtung des Zuleitungsrohres 4 ausgerichtete Bewegungskomponente, so dass sich das Aerosol gleichmäßiger in einem Abstandsraum 9,10 verteilt als es der Fall wäre, wenn aus der Mündung 4' ein in Erstreckungsrichtung des Zuleitungsrohres 4 gerichteter Gasstrom austreten würde.

Die Bezugsziffer 31 bezeichnet einen Gewindeabschnitt, mit dem das Zuleitungsrohr 4 in ein nicht dargestelltes Gehäuse eingeschraubt werden kann. Zum Angriff eines Schraubwerkzeuges ist ein Schraubwerkzeugangriffsprofil 32 in Form von zwei sich gegenüberliegenden Flachflächen vorgesehen.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:

Eine Vorrichtung, die dadurch gekennzeichnet ist, dass zumindest einer der Wärmeübertragungskörper 1, 2, 3 eine Öffnung 6, 7, 8 aufweist, in der ein Zuleitungsrohr 4, 5 steckt.

Eine Vorrichtung, die dadurch gekennzeichnet ist, dass das Zuleitungsrohr 4, 5 durch die Öffnung 6, 7, 8 des Wärmeübertragungskörpers 1, 2, 3 hindurch geführt ist und in einem Abstandsraum 9,10 zwischen zwei aneinander angrenzenden Wärmeübertragungskörpern 1, 2; 2, 3 oder in einen anderen Wärmeübertragungskörper 2, 3 mündet.

Eine Vorrichtung, die dadurch gekennzeichnet ist, dass die Öffnung 6, 7 einem stromaufwärtigen Wärmeübertragungskörper 1, 2 zugeordnet ist und die Mündung 4', 5' des Zuleitungsrohres 4, 5 in Strömungsrichtung vor einem stromabwärtigen Wärmeübertragungskörper 2, 3 oder in einem stromabwärtigen Wärmeübertragungskörper 2, 3 angeordnet ist.

Eine Vorrichtung, die dadurch gekennzeichnet ist, dass ein in Strömungsrichtung erster, stromaufwärtiger Wärmeübertragungskörper lein Vorheizkörper für das Trägergas ist, das durch eine Trägergaszuleitung 11 in ein Gehäuse 12 einspeisbar ist, in welchem Gehäuse 12 die Wärmeübertragungskörper 1, 2, 3 in Strömungsrichtung derart hintereinander angeordnet sind, dass das Trägergas sämtliche Wärmeübertragungskörper 1, 2, 3 durchströmt.

Eine Vorrichtung, die dadurch gekennzeichnet ist, dass die Wärmeübertragungskörper 1, 2, 3 aus einem offenporigen Festkörperschaum bestehen, der eine Porösität von 500 bis 100 Poren pro Zoll aufweist, wobei insbesondere der Anteil aller offenen Flächen an der Oberfläche des Festkörperschaums größer als 90 % ist.

Eine Vorrichtung, die dadurch gekennzeichnet ist, dass der Wärmeübertragungskörper elektrisch leitend ist und elektrische Kontakte 20, 21 aufweist zum Durchleiten eines elektrischen Stroms zwecks Aufheizen des Wärmeübertragungskörpers 1, 2, 3 auf eine Wärmeübertragungstemperatur.

Eine Vorrichtung, die dadurch gekennzeichnet ist, dass in Strömungsrichtung hintereinander angeordnete Wärmeübertragungskörper 1, 2, 3 auf voneinander verschiedene Temperaturen aufheizbar sind, wobei die Wärmeübertragungstemperatur eines stromabwärtigen Wärmeübertragungskörpers 2, 3 größer ist als die Wärmeübertragungstemperatur eines stromaufwärtigen Wärmeübertragungskörpers 1, 2.

Eine Vorrichtung, die dadurch gekennzeichnet ist, dass das Zuleitungsrohr Mittel 29, 30, 27 aufweist, um den in Strömungsrichtung S durch das Zuleitungsrohr 4 hindurchtretenden Aerosolstrom aufgeweitet aus der Mündung 4' austreten zu lassen.

Eine Vorrichtung, die dadurch gekennzeichnet ist, dass das Zuleitungsrohr 4 einen ersten Strömungskanal 23 zum Einspeisen des Aerosols und einen zweiten Strömungskanal 24 zum Einspeisen eines Trägergases aufweist, wobei Gasdurchtrittsöffnungen 29, 30 vorgesehen sind, durch die das Trägergas aus dem zweiten Strömungskanal 24 in den ersten Strömungskanal 23 strömen kann und wobei insbesondere vorgesehen ist, dass der zweite Strömungskanal 24 im Bereich der Mündung 4' des Zuleitungsrohres verschlossen ist.

Eine Vorrichtung, die dadurch gekennzeichnet ist, dass erste Gasdurchtrittsöffnungen 29 in einem derartigen Winkel zur Strömungsrichtung S des Aerosols in den ersten Strömungskanal 23 münden, dass der durch die ersten Gasdurchtrittsöffnungen 29 hindurchtretende Trägergasstrom im ersten Strömungskanal 23 eine Turbulenz erzeugt, wobei insbesondere vorgesehen ist, dass der zweite Strömungskanal 24 den ersten Strömungskanal 23 umgibt.

Eine Vorrichtung, die dadurch gekennzeichnet ist, dass zweite Gasdurchtrittsöffnungen 30 in einem derartigen Winkel zur Strömungsrichtung S des Aerosols im ersten Strömungskanal 23 angeordnet sind, dass ein durch die zweiten Gasdurchtrittsöffnungen 30 hindurchtretender Trägergasstrom im Bereich der Mündung 4' einen Wirbel um eine in Strömungsrichtung S ausgerichtete Achse erzeugt.

Eine Vorrichtung, die dadurch gekennzeichnet ist, dass ein den ersten Strömungskanal 23 ausbildendes Rohr 33 im Bereich der Mündung 4' eine insbesondere rotationssymmetrische Aufweitung 27 aufweist.

Eine Vorrichtung, die dadurch gekennzeichnet ist, dass der in der Öffnung 6, 7, 8 steckende Abschnitt des Zuleitungsrohres 4, 5 von einer Isolationshülse 28 umgeben ist.

Eine Vorrichtung, die gekennzeichnet ist durch Mittel zur Kühlung der Wandung des Strömungskanals 23, durch welchen das Aerosol hindurch strömt.

Eine Vorrichtung, die dadurch gekennzeichnet ist, dass die Mittel zur Kühlung einen Strömungskanal 23 aufweisen, durch den ein Kühlmittel hindurch leitbar ist.

Eine Vorrichtung, die dadurch gekennzeichnet ist, dass in Strömungsrichtung vor dem Wärmeübertragungskörper 1 eine Rückstromsperre 18,19 angeordnet ist, welche Rückstromsperre 18,19 insbesondere von zwei sich über den gesamten Strömungsquerschnitt erstreckenden, dicht benachbarten Platten gebildet sind, die Öffnungen 18',19' aufweisen, wobei die Öffnungen 18',19' voneinander verschiedener Platten quer zur Strömungsrichtung versetzt zueinander angeordnet sind.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren mit ihren Merkmalen eigenständige erfinderische Weiterbildungen des Standes der Technik, insbesondere um auf Basis dieser Ansprüche Teilanmeldungen vorzunehmen.

**Bezugszeichenliste:**

| | | | |
|---|---|---|---|
| 1 | Wärmeübertragungskörper | 20 | elektrische Kontakte |
| 2 | Wärmeübertragungskörper | 21 | elektrische Kontakte |
| 3 | Wärmeübertragungskörper | 22 | Gasaustrittsöffnung |
| 3' | Unterseite | 23 | Strömungskanal |
| 4 | Zuleitungsrohr | 24 | Strömungskanal |
| 4' | Mündung | 25 | Einspeiseöffnung |
| 5 | Zuleitungsrohr | 26 | Einspeiseöffnung |
| 5' | Mündung | 27 | Aufweitung |
| 6 | Öffnung | 28 | Isolierhülse |
| 7 | Öffnung | 29 | Gasdurchtrittsöffnung |
| 8 | Öffnung | 30 | Gasdurchtrittsöffnung |
| 9 | Abstandsraum | 31 | Gewindeabschnitt |
| 10 | Abstandsraum | 32 | Schraubwerkzeugangriffsprofil |
| 11 | Trägergaszuleitung | 33 | Innenrohr |
| 12 | Gehäuse | 34 | Außenrohr |
| 13 | Suszeptor | | |
| 14 | Substrat | | |
| 15 | Prozesskammer | | |
| 16 | Gaseinlassorgan | | |
| 17 | CVD-Reaktor | | |
| 18 | Rückstromsperrplatte | | |
| 18' | Öffnung | | |
| 19 | Rückstromsperrplatte | | |
| 19' | Öffnung | | |

## Patentansprüche

1. Vorrichtung zum Erzeugen eines Dampfes für eine CVD- oder PVD-Einrichtung mit mindestens zwei in Strömungsrichtung eines Trägergases hintereinander in einem Gehäuse (12) angeordneten, Wärmeübertragungsflächen aufweisende Wärmeübertragungskörper (1, 2, 3), die jeweils auf eine Wärmeübertragungstemperatur aufheizbar sind, mit einem Zuleitungsrohr (4, 5) zur Zuleitung eines Aerosols zu einem der Wärmeübertragungskörper (2, 3) zur Verdampfung des Aerosols durch In-Kontakt-Bringen der Aerosol-Partikel mit den Wärmeübertragungsflächen, wobei, zumindest einer der Wärmeübertragungskörper (1, 2, 3) eine Öffnung (6, 7, 8) aufweist, in der ein Zuleitungsrohr (4, 5) steckt, **dadurch gekennzeichnet, dass** die Wärmeübertragungskörper (1, 2, 3) auf voneinander verschiedene Temperaturen aufheizbar sind, wobei ein in Strömungsrichtung erster, stromaufwärtiger Wärmeübertragungskörper (1) ein Vorheizkörper für das Trägergas ist, das durch eine Trägergaszuleitung (11) stromaufwärts des ersten Wärmeübertragungskörpers in das Gehäuse (12) einspeisbar ist, in welchem Gehäuse (12) die Wärmeübertragungskörper (1, 2, 3) in Strömungsrichtung derart hintereinander angeordnet sind, dass das Trägergas sämtliche Wärmeübertragungskörper (1, 2, 3) durchströmt und, entweder das Zuleitungsrohr (4, 5) durch die Öffnung (6, 7, 8) eines Wärmeübertragungskörper (1, 2, 3) hindurch geführt ist und in einem Abstandsraum (9,10) zwischen dem ersten und dem zweiten Wärmeübertragungsköper (1, 2; 2,3) mündet oder die Mündung (4' 5') des Zuleitungsrohres (4, 5) in einem Wärmeübertragungskörper (2, 3) angeordnet ist.

2. Vorrichtung nach Anspruch 1, **dadurch gekennzeichnet, dass** die Öffnung (6, 7) einem stromaufwärtigen Wärmeübertragungskörper (1, 2) zugeordnet ist und die Mündung (4', 5') des Zuleitungsrohres (4, 5) in Strömungsrichtung vor einem stromabwärtigen Wärmeübertragungskörper (2, 3) oder in einem stromabwärtigen Wärmeübertragungskörper (2, 3) angeordnet ist.

3. Vorrichtung nach einem der vorangehenden Ansprüche, **dadurch gekennzeichnet, dass** die Wärmeübertragungskörper (1, 2, 3) aus einem offenporigen Festkörperschaum bestehen, der eine Porösität von 500 bis 100 Poren pro Zoll aufweist, wobei der Anteil aller offenen Flächen an der Oberfläche des Festkörperschaums größer als 90 % ist.

4. Vorrichtung nach einem der vorangehenden Ansprüche, **dadurch gekennzeichnet, dass** die Wärmeübertragungskörper (1, 2, 3) elektrisch leitend sind und elektrische Kontakte (20, 21) aufweisen zum Durchleiten eines elektrischen Stroms zwecks Aufheizen der Wärmeübertragungskörpers (1, 2, 3) auf eine Wärmeübertragungstemperatur.

5. Vorrichtung nach einem der vorangehenden Ansprüche, **dadurch gekennzeichnet, dass** die Wärmeübertragungskörper (1, 2, 3) derart beheizbar sind, dass die Wärmeübertragungstemperatur eines stromabwärtigen Wärmeübertragungskörpers (2, 3) größer ist als die Wärmeübertragungstemperatur eines stromaufwärtigen Wärmeübertragungskörpers (1, 2).

6. Vorrichtung nach einem der vorangehenden Ansprüche, **dadurch gekennzeichnet, dass** das Zuleitungsrohr Mittel (29, 30; 27) aufweist, um den in Strömungsrichtung (S) durch das Zuleitungsrohr (4) hindurchtretenden Aerosolstrom aufgeweitet aus der Mündung (4') austreten zu lassen.

7. Vorrichtung nach Anspruch 6, **dadurch gekennzeichnet, dass** das Zuleitungsrohr (4) einen ersten Strömungskanal (23) zum Einspeisen des Aerosols und einen zweiten Strömungskanal (24) zum Einspeisen eines Trägergases aufweist, wobei Gasdurchtrittsöffnungen (29, 30) vorgesehen sind, durch die das Trägergas aus dem zweiten Strömungskanal (24) in den ersten Strömungskanal (23) strömen kann und wobei insbesondere vorgesehen ist, dass der zweite Strömungskanal (24) im Bereich der Mündung (4') des Zuleitungsrohres verschlossen ist.

8. Vorrichtung nach Anspruch 7, **dadurch gekennzeichnet, dass** erste Gasdurchtrittsöffnungen (29) in einem derartigen Winkel zur Strömungsrichtung (S) des Aerosols in den ersten Strömungskanal (23) münden, dass der durch die ersten Gasdurchtrittsöffnungen (29) hindurchtretende Trägergasstrom im ersten Strömungskanal (23) eine Turbulenz erzeugt, wobei insbesondere vorgesehen ist, dass der zweite Strömungskanal (24) den ersten Strömungskanal (23) umgibt.

9. Vorrichtung nach Anspruch 7 oder 8, **dadurch gekennzeichnet, dass** zweite Gasdurchtrittsöffnungen (30) in einem derartigen Winkel zur Strömungsrichtung (S) des Aerosols im ersten Strömungskanal (23) angeordnet sind, dass ein durch die zweiten Gasdurchtrittsöffnungen (30) hindurchtretender Trägergasstrom im Bereich der Mündung (4') einen Wirbel um eine in Strömungsrichtung (S) ausgerichtete Achse erzeugt.

10. Vorrichtung nach Anspruch 7,8 oder 9, **dadurch gekennzeichnet, dass** ein den ersten Strömungskanal (23) ausbildendes Rohr (33) im Bereich der Mündung (4') eine insbesondere rotationssymmetrische Aufweitung (27) aufweist.

11. Vorrichtung nach einem der vorangehenden Ansprüche, **dadurch gekennzeichnet, dass** der in der Öffnung (6, 7, 8) steckende Abschnitt des Zuleitungsrohres (4, 5) von einer Isolationshülse (28) umgeben ist.

12. Vorrichtung nach einem der Ansprüche 7 bis 10, **gekennzeichnet durch** Mittel zur Kühlung der Wandung des Strömungskanals (23), durch welchen das Aerosol hindurch strömt.

13. Vorrichtung nach Anspruch 12, **dadurch gekennzeichnet, dass** die Mittel zur Kühlung einen Strömungskanal (23) aufweisen, durch den ein Kühlmittel hindurch leitbar ist.

14. Vorrichtung nach einem der vorangehenden Ansprüche, wobei stromaufwärts des Wärmeübertragungskörpers (1) eine Trägergaszuleitung (11) vorgesehen ist, zum Einspeisen eines Trägergases, **dadurch gekennzeichnet, dass** in Strömungsrichtung vor dem Wärmeübertragungskörper (1) eine Rückstromsperre (18,19) angeordnet ist, welche Rückstromsperre (18, 19) insbesondere von zwei sich über den gesamten Strömungsquerschnitt erstreckenden, dicht benachbarten Platten gebildet sind, die Öffnungen (18',19') aufweisen, wobei die Öffnungen (18', 19') voneinander verschiedener Platten quer zur Strömungsrichtung versetzt zueinander angeordnet sind.

## Claims

1. A device for generating a vapor for a CVD or PVD apparatus, with at least two thermal transfer bodies (1, 2, 3) arranged successively in a housing (12) in the direction of flow of a carrier gas and having thermal transfer surfaces, each of which can be heated to a thermal transfer temperature, with an inlet pipe (4, 5) for feeding an aerosol to one of the thermal transfer bodies (2, 3) for vaporization of the aerosol by bringing the aerosol particles into contact with the thermal transfer surfaces, wherein at least one of the thermal transfer bodies (1, 2, 3) has an opening (6, 7, 8) in which an inlet pipe (4, 5) is located, **characterized in that** the thermal transfer bodies (1, 2, 3) can be heated to different temperatures, an upstream thermal transfer body (1) first in the direction of flow being a preheating body for the carrier gas, which can be fed through a carrier gas feed line (11) upstream from the first thermal transfer body into the housing (12), in which housing (12) the thermal transfer bodies (1, 2, 3) are arranged successively in the direction of flow such that the carrier gas flows through all of the thermal transfer bodies (1, 2, 3) and either the inlet pipe (4, 5) is guided through the opening (6, 7, 8) of a thermal transfer body (1, 2, 3) and leads into a spacing gap (9,10) between the first and the second thermal transfer bodies (1, 2; 2, 3) or the mouth (4', 5') of the inlet pipe (4, 5) is arranged in a thermal transfer body (2,3).

2. The device as set forth in claim 1, **characterized in that** the opening (6, 7) is associated with an upstream thermal transfer body (1, 2) and the mouth (4', 5') of the inlet pipe (4, 5) is arranged in the direction of flow before a downstream thermal transfer body (2, 3) or in a downstream thermal transfer body (2, 3).

3. The device as set forth in any one of the preceding claims, **characterized in that** the thermal transfer bodies (1, 2, 3) are made of an open-pored solid foam having a porosity of 500 to 100 pores per inch, the proportion of all open areas on the surface of the solid foam being greater than 90%.

4. The device as set forth in any one of the preceding claims, **characterized in that** the thermal transfer bodies (1,2,3) are electrically conductive and have electrical contacts (20, 21) for conducting an electrical current for the purpose of heating the thermal transfer body (1, 2, 3) to a thermal transfer temperature.

5. The device as set forth in any one of the preceding claims, **characterized in that** the thermal transfer bodies (1, 2, 3) can be heated such that the thermal transfer temperature of a downstream thermal transfer body (2,3) is greater than the thermal transfer temperature of an upstream thermal transfer body (1, 2).

6. The device as set forth in any one of the preceding claims, **characterized in that** the inlet pipe has means (29, 30; 27) for allowing the aerosol flow passing in the direction of flow (S) through the inlet pipe (4) to emerge from the mouth (4') in expanded form.

7. The device as set forth in claim 6, **characterized in that** the inlet pipe (4) has a first flow channel (23) for feeding the aerosol in and a second flow channel (24) for feeding a carrier gas in, wherein gas passage openings (29, 30) are provided through which the carrier gas can flow out of the second flow channel (24) into the first flow channel (23) and wherein a provision is particularly made that the second flow channel (24) is sealed in the area of the mouth (4') of the inlet pipe.

8. The device as set forth in claim 7, **characterized in that** first gas passage openings (29) lead into the first flow channel (23) at such an angle to the direction of flow (S) of the aerosol that the carrier gas flow passing through the first gas passage openings (29) generates turbulence in the first flow channel (23), a provision particularly being made that the second flow channel (24) encloses the first flow channel (23).

9. The device as set forth in claim 7 or 8, **characterized in that** second gas passage openings (30) are arranged in the first flow channel (23) at such an angle to the direction of flow (S) of the aerosol that a carrier gas flow passing through the second gas passage openings (30) generates a vortex in the area of the mouth (4') about an axis aligned in the direction of flow (S).

10. The device as set forth in claim 7, 8 or 9, **characterized in that** a pipe (33) forming the first flow channel (23) has a particularly rotationally symmetrical widening (27) in the area of the mouth (4').

11. The device as set forth in any one of the preceding claims, **characterized in that** the section of the inlet pipe (4, 5) located in the opening (6, 7, 8) is enclosed by an insulating sleeve (28).

12. The device as set forth in any one of the claims 7 to 10, **characterized by** means for cooling the wall of the flow channel (23) through which the aerosol flows.

13. The device as set forth in claim 12, **characterized in that** the means for cooling has a flow channel (23) through which a coolant can be conducted.

14. The device as set forth in any one of the preceding claims, wherein a carrier gas feed line (11) is provided upstream from the thermal transfer body (1) for feeding in a carrier gas, **characterized in that** a return flow check valve (18,19) is arranged in the direction of flow before the thermal transfer body (1), which return flow check valve (18, 19) is particularly formed by two tightly adjacent plates extending over the entire flow cross section that have openings (18', 19'), the openings (18', 19') of different plates being arranged so as to be offset with respect to each other transverse to the direction of flow.

## Revendications

1. Dispositif pour générer une vapeur pour un dispositif CVD ou PVD avec au moins deux corps de transfert de chaleur (1, 2, 3) disposés dans un boîtier (12) l'un derrière l'autre dans la direction d'écoulement d'un gaz porteur, et ayant des surfaces de transfert de chaleur, qui peuvent être chauffés respectivement jusqu'à une température de transfert de chaleur, avec un tuyau d'alimentation (4, 5) pour délivrer un aérosol à l'un des corps de transfert de chaleur (2, 3) pour vaporisation de l'aérosol en mettant en contact les particules d'aérosol avec les surfaces de transfert de chaleur, dans lequel au moins l'un des corps de transfert de chaleur (1, 2, 3) a une ouverture (6, 7, 8), dans laquelle se trouve un tuyau d'alimentation (4, 5), **caractérisé en ce que** les corps de transfert de chaleur (1, 2, 3) peuvent être chauffés à des températures différentes les unes des autres, dans lequel un premier corps de transfert de chaleur (1) en amont dans la direction d'écoulement est un corps de préchauffage pour le gaz porteur, qui peut être alimenté dans ledit boîtier (12)par une conduite d'alimentation en gaz porteur (11) en amont du premier corps de transfert de chaleur, les corps de transfert de chaleur (1, 2, 3) étant disposés dans le boitier (12) l'un derrière l'autre dans la direction d'écoulement de telle sorte que le gaz porteur passe à travers tous les corps de transfert de chaleur (1, 2, 3) et, soit le tuyau d'alimentation (4, 5) est guidé à travers l'ouverture (6, 7, 8) d'un corps de transfert de chaleur et débouche dans un espace intermédiaire (9,10) entre le premier et le deuxième corps de transfert de chaleur (1, 2 ; 2,3) soit l'orifice de sortie (4'5') du tuyau d'alimentation (4, 5) est disposée dans un corps de transfert de chaleur (2, 3).

2. Dispositif selon la revendication 1, **caractérisé en ce que** l'ouverture (6, 7) est associée à un corps de transfert de chaleur (1, 2) amont et l'orifice de sortie (4', 5') du tuyau d'alimentation (4, 5) est disposé devant un corps de transfert de chaleur (2, 3) aval ou dans un corps de transfert de chaleur (2, 3) en aval dans la direction d'écoulement.

3. Dispositif selon l'une quelconque des revendications précédentes, **caractérisé en ce que** les corps de transfert de chaleur (1, 2, 3) sont constitués d'une mousse solide à pores ouverts ayant une porosité de 500 à 100 pores par pouce, dans lequel la proportion de l'ensemble des surfaces ou zones ouvertes sur la surface de la mousse solide est supérieure à 90%.

4. Dispositif selon l'une quelconque des revendications précédentes, **caractérisé en ce que** les corps de transfert de chaleur (1, 2, 3) sont conducteurs électriques et ont des contacts électriques (20, 21) pour faire passer un courant électrique dans le but de chauffer les corps de transfert de chaleur (1, 2, 3) jusqu'à une température de transfert de chaleur.

5. Dispositif selon l'une quelconque des revendications précédentes, **caractérisé en ce que** les corps de transfert de chaleur (1, 2, 3) peuvent être chauffés de telle manière que la température de transfert de chaleur d'un corps de transfert de chaleur (2, 3) aval est supérieure à la température de transfert de chaleur d'un corps de transfert de chaleur (1, 2) amont.

6. Dispositif selon l'une quelconque des revendications précédentes, **caractérisé en ce que** le tuyau d'alimentation (27 29, 30) comprend des moyens pour permettre au flux d'aérosol passant dans la direction d'écoulement (S) à travers le tuyau d'alimentation (4) de sortir de l'orifice de sortie (4') sous forme expansée.

7. Dispositif selon la revendication 6, **caractérisé en ce que** le tuyau d'alimentation (4) comprend un premier canal d'écoulement (23) pour introduction de l'aérosol et un deuxième canal d'écoulement (24) pour introduction d'un gaz porteur, dans lequel des ouvertures de passage de gaz (29, 30) sont prévues à travers lesquelles le gaz porteur peut s'écouler (23), du deuxième canal d'écoulement (24) vers le premier canal d'écoulement, et dans lequel il est prévu, en particulier, que le deuxième canal d'écoulement (24) est fermé dans la région de l'orifice de sortie (4') du tuyau d'alimentation.

8. Dispositif selon la revendication 7, **caractérisé en ce que** des premières ouvertures de passage de gaz (29) débouchent dans le premier canal d'écoulement (23) à un angle par rapport à la direction d'écoulement (S) de l'aérosol tel que le gaz porteur passant à travers les premières ouvertures de passage de gaz (29) crée une turbulence dans le premier canal d'écoulement (23), dans lequel il est en particulier prévu que le deuxième canal d'écoulement (24) entoure le premier canal d'écoulement (23).

9. Dispositif selon l'une quelconque des revendications 7 ou 8, **caractérisé en ce que** des deuxièmes ouvertures de passage de gaz (30) sont disposées à un angle tel par rapport à la direction d'écoulement (S) de l'aérosol dans le premier canal d'écoulement (23) qu'un écoulement de gaz porteur à travers les deuxièmes ouvertures de passage de gaz (30) crée un vortex autour d'un axe aligné dans la direction d'écoulement (S) dans la région de l'orifice de sortie (4').

10. Dispositif selon l'une quelconque des revendications 7, 8 ou 9, **caractérisé en ce qu'**un tuyau (33) formant le premier canal d'écoulement (23) présente un élargissement (27), en particulier symétrique en rotation, dans la zone de l'orifice de sortie (4').

11. Dispositif selon l'une quelconque des revendications précédentes, **caractérisé en ce que** la section du tuyau d'alimentation (4, 5) située dans l'ouverture (6, 7, 8) est entourée par un manchon isolant (28).

12. Dispositif selon l'une quelconque des revendications 7 à 10, **caractérisé par** des moyens de refroidissement de la paroi du canal d'écoulement (23) à travers laquelle s'écoule l'aérosol.

13. Dispositif selon la revendication 12, **caractérisé en ce que** les moyens de refroidissement ont un canal d'écoulement (23) à travers lequel un fluide de refroidissement peut être conduit.

14. Dispositif selon l'une quelconque des revendications précédentes, dans lequel une conduite d'alimentation (11) de gaz porteur est prévue en amont du corps de transfert de chaleur (1) pour introduction d'un gaz porteur, **caractérisé en ce qu'**un clapet anti-retour (18 , 19) est disposé avant le corps de transfert de chaleur (1) dans la direction d'écoulement, le clapet anti-retour (18, 19) étant formé en particulier par deux plaques très proches l'une de l'autre s'étendant sur toute la section transversale d'écoulement, qui comprennent des ouvertures (18', 19'), dans lequel les ouvertures (18', 19') des plaques différentes l'une de l'autre sont agencées de manière à être décalées les unes par rapport aux autres, transversalement à la direction d'écoulement.
